# EUROPEAN PATENT APPLICATION

(11) **EP 3 012 805 A1**
(43) Date of publication of application: **27.04.2016**
(21) Application number: 14189661.3
(22) Date of filing: 21.10.2014
(51) Int. Cl.: G06T 15/50, G06T 19/20

(54) **Synthesizing an image of fibers**

(71) Applicant: The Procter & Gamble Company, Cincinnati, OH 45202 (US)
(72) Inventor: Degenhard, Thomas, 65824 Schwalbach (DE); Godfrey, Simon Paul, 65824 Schwalbach (DE); Herrlein, Mathias Kurt, 65824 Schwalbach (DE); Hirn, Thomas Wolfgang Friedrich, 65824 Schwalbach (DE); Mckelvey, Graham Neil, 65824 Schwalbach (DE); Zinke, Arno, 53117 Bonn (DE)
(74) Representative: Hirsch, Uwe Thomas M.H.

(57) **Abstract**

A method and apparatus for synthesizing an image showing fibers. The method comprises providing (210) a computational model describing the interaction of light with fibers; obtaining (220) a first set of fiber parameters, which describes a plurality of real fibers (160), for use with the model; modifying (230) the first set of fiber parameters, to produce a second set of fiber parameters describing a plurality of modified fibers; simulating (240), using the model and the second set of fiber parameters, how light would interact with the modified fibers; and rendering (250), based on the result of the simulation, a synthetic image showing the appearance of the modified fibers.

## Description

### FIELD OF THE INVENTION

This invention relates to a method and apparatus for synthesizing an image - in particular, an image showing a plurality of fibers. In some embodiments, the method and apparatus can be used to generate synthetic images of human hair. These embodiments may be particularly relevant for specifying a desired appearance of the hair, such as a desired hair color to be achieved by treatments such as dyeing.

### BACKGROUND OF THE INVENTION

Systems for hair-color advice or hair-color consultation have been proposed in the past. In a typical example, a camera captures an image or video of a person's head; a hair region of the image or video is identified; an image processing operation is performed on the hair region, modifying the color of the hair region; and the modified image is displayed on a display screen. The idea is that the person can then judge, from the modified image, how they would appear if their hair had the modified color.

A problem with this approach is that it does not provide a realistic impression of the potential appearance of the hair. The manipulation of the color is performed directly on the image pixels - for example, directly modifying the RGB values of the pixels in the hair region. There may be little similarity between the color presented in the resulting modified image and any hair color actually achievable in the real world. For example, it may be physically impossible for any hair to appear in that color, under the illumination conditions in which the image or video was captured. The modified image or video presented to the person may be physically unrealizable in practice, and/or may appear unnatural to the person. Because of these problems, the practical utility of such systems is limited.

### SUMMARY OF THE INVENTION

The invention is defined by the claims.

According to one aspect, there is disclosed a method of synthesizing an image showing fibers, the method comprising:
providing a computational model describing the interaction of light with fibers;
obtaining a first set of fiber parameters, which describes a plurality of real fibers, for use with the model;
modifying the first set of fiber parameters, to produce a second set of fiber parameters describing a plurality of modified fibers;
simulating, using the model and the second set of fiber parameters, how light would interact with the modified fibers; and
rendering, based on the result of the simulation, a synthetic image showing the appearance of the modified fibers.

This method can allow photorealistic images of fibers to be produced, because it can model the way in which light actually interacts with fibers. By starting with parameters that describe a plurality of real fibers, and then modifying those parameters, the synthetic image can accurately represent the appearance of a modified version of the original fibers. And, because the modified parameters are still tied to the computational model, it can be ensured that the appearance of these modified fibers is - at least in principle - physically realizable. That is, it is possible for some fibers in the real world to have this appearance. In contrast, if a "real" image of the original fibers is modified directly, such as by using conventional image processing techniques, there is no confidence that the result will either look realistic, or will represent something that is physically realizable.

The step of simulating the interaction of light with the fibers may comprise calculating, using a processor, how light illuminating the modified fibers would be scattered and/or absorbed by those fibers. Scattering interactions may include at least one of: reflection and refraction.

In general, the parameters of the fibers used in the model are optical parameters, characterizing various aspects of the interactions between the fibers and incident light.

The interaction of light with the fibers may include at least one of (or any combination of two or more of) the following physical interactions: specular reflection; diffuse reflection; absorption; refraction; and transmission. As used herein, the term "scattering" refers to non-absorptive interactions between light and fibers.

Preferably, the first set of fiber parameters is obtainable by physical measurement and analysis of the real fibers. That is, the parameters may be derived from actual material fiber samples.

The modification of the first set of fiber parameters may represent or approximate a physical modification of the real fibers - for example, a treatment applied to the real fibers, such as a chemical treatment.The chemical treatment may comprise at least one of (or any combination of two or more of): a pigment, structural color, dye, polymeric dye, optical effect and bleaching.

Each of the first and second sets of fiber parameters may comprise parameters for at least three of the following four components: a first backward scattering component, describing how incident light is reflected from a first surface of a fiber; a first forward scattering component, describing how incident light is transmitted through the first surface of the fiber and a second surface of the fiber; a second backward scattering component, describing how incident light is transmitted through the first surface of the fiber, reflected from the second surface of the fiber, and transmitted through a third surface of the fiber; and an absorption component, describing how incident light is absorbed by the fiber.

The first, second, and third surfaces may be different parts of the same continuous surface - for example, if the fiber is modeled as a cylinder. The first backward scattering component may represent a reflection from an exterior surface of the fiber. The first forward scattering component may represent a first refraction as light enters the fiber at the first surface and a second refraction as the light exits the fiber at the second surface. The second backward scattering component may represent a refraction as light enters the fiber at the first surface; an internal reflection at the second surface; and a further refraction as the light exits the fiber at the third surface.

The step of modifying the first set of parameters may comprise modifying at least one parameter related to a color of the real fibers, whereby the second set of parameters describes fibers having a modified color.

Optionally, modifying at least one parameter related to the color of the fibers comprises modifying at least one parameter related to a reflection spectrum, transmission spectrum, or absorption spectrum of the fibers. The modification may change the amplitude of one of these spectra in its entirety, or may change the amplitude at some wavelengths only, thereby changing the wavelength dependence of the spectra. The modification may represent a change in at least one of (or any combination of two or more of): the lightness, chroma, hue, and color saturation of the fibers. Lightness, chroma, and hue may be defined in the same way as specified in the CIE LCH color space.

Alternatively or in addition, modifying the first set of parameters may comprise modifying at least one parameter related to the shine of the real fibers. For example, at least one parameter related to the angular dependence of reflectance may be modified.

The step of obtaining the first set of fiber parameters preferably comprises: obtaining an image of the plurality of real fibers; processing the image to determine a set of estimated fiber parameters; simulating, using the model and the estimated fiber parameters, how light would interact with fibers with the estimated parameters; computing an error metric comparing the result of the simulation with the content of the image; updating the estimated parameters, based on the error metric; iterating the steps of simulating, computing, and updating, until the estimated fiber parameters converge to stable values; and determining the first set of fiber parameters based on the converged estimated fiber parameters.

This can provide a type of "analysis-by-synthesis" approach to measuring the fiber parameters of real fibers. The parameters are derived iteratively, by simulating how light would interact with fibers assuming that they had the currently estimated parameters, and comparing the results of the simulation with the appearance of the real fibers. The parameters are then updated, and the simulation and comparison are performed again, to see if the new parameters match the real fibers better or worse. After several iterations, this approach can converge to a set of parameters that accurately models the real fibers. This approach can avoid the need for expensive specialist equipment (such as a gonioreflectometer) and a time- or labour-intensive measurement and analysis process. Preferably, the only "measurement" needed is to photograph the plurality of real fibers, producing a digital image. This has many advantages. For example, if the fibers comprise human hair, it may be possible to determine the fiber parameters of real hair from hair on a person's head, without the need to cut off a hair sample.

The image of the plurality of real fibers is preferably a high dynamic range image. This can allow more accurate results, in the estimation of the parameters.

Each of the first and second sets of fiber parameters optionally comprises parameters describing an average fiber; and the model optionally describes respective individual fibers by combining the parameters of the average fiber with a random perturbation.

The inventors have recognized that this is a good way to approximate the variations found among natural fibers in the real world. Usually, no two fibers will be identical; however, maintaining a set of parameters for every individual fiber may be prohibitively complicated. The random perturbation may comprise modification of the average parameters by a pseudo-random noise component - for example, computing the sum or product of the average parameters with a pseudo-random variable.

The synthetic image may comprise a plurality of pixels. Preferably, simulating how light would interact with the modified fibers comprises simulating, for each of a plurality of rays of light arriving at each pixel, a journey of the ray from a light source to that pixel, said journey including an interaction with one or more of the modified fibers.

The synthetic image may comprise a plurality of pixels corresponding to a respective plurality of spatial positions in a virtual image plane, and simulating how light would interact with the modified fibers may comprise simulating, for each of a plurality of rays of light arriving at each position, a journey of the ray from a light source to the position, said journey including an interaction with one or more of the modified fibers, wherein the simulation comprises calculations performed in parallel by two or more computing devices, each computing device simulating, for each position, the journeys of a subset of the plurality of rays to that position.

Here, "parallel" means that one calculation begins before another ends.

The two or more computing devices may comprise two or more cores in the same microprocessor; two or more microprocessors (for example, connected by a bus) in the same computer; or two or more microprocessors in respective different computers (for example, connected by a network).

The step of rendering the synthetic image may comprise calculating a pixel value by combining contributions to the pixel from the plurality of rays, and the method may comprise rendering and displaying a preliminary synthetic image before the simulation has completed, based on the contributions to each pixel from rays that have been simulated up to the current time.

Here "completing" a simulation refers to calculating an intended number of samples per pixel. Thus, in this case, the method comprises rendering and displaying a preliminary synthetic image, followed by continuing to calculate more samples for each pixel. The preliminary image will be an approximation to the final image, to be obtained after the full set of samples has been calculated. This can provide progressive rendering, whereby the image is initially displayed in relatively lower quality, after a first number of samples per pixel has been calculated, and then later displayed in relatively higher quality, after additional samples per pixel have been calculated.

The method optionally further comprises, after the step of rendering and displaying the preliminary synthetic image: interrupting the simulation; further modifying the second set of fiber parameters to produce a third set of fiber parameters describing a plurality of further modified fibers; simulating, using the model and the third set of fiber parameters, how light would interact with the further modified fibers; and rendering, based on the result of the simulation, a synthetic image showing the appearance of the further modified fibers.

The simulation can be interrupted and restarted with new parameters - for example, if a user does not like the appearance of the modified fibers in the preliminary image. Although the preliminary image may be somewhat noisy, compared with a finished synthetic image, it may nevertheless be possible to get an initial impression of the appearance of the fibers. If the user does not like the appearance, the fiber parameters can be changed, so that the further modified fibers will be more similar to the appearance that is desired by the user. This allows the user to define the appearance of the fibers iteratively, without the delay of waiting for a full simulation to complete. Since the simulations are typically computationally intensive, this can result in a significant increase in speed, for the overall process.

The second set of fiber parameters optionally includes at least one parameter that has a different value for at least one of the following: different fibers among the plurality of fibers; and different parts of the same fiber.

For example, this can model different hairs on different parts of the same head having different optical properties (such as color or shine). Alternatively or in addition, it can model variations in optical properties (such as color or lightness) along the length of individual hairs, for some or all of the hairs - for example, a differently colored root, at an end of the hair fiber nearest to the scalp. It may be advantageous to include both kinds of variations to make the synthetic image more realistic and natural looking. As discussed already above, different colors may be characterised by differing lightness, chroma, hue and/or color saturation.

The method may further comprise obtaining light source parameters for use with the model, which describe a light source; the method comprising simulating, using the model, the light source parameters, and the second set of fiber parameters, how light from the light source would interact with the modified fibers, wherein the light source parameters comprise an omnidirectional image.

Such omnidirectional images are also known as "light probe" images. They record the incident illumination conditions at a particular point in space, from substantially all directions. When using a light probe image as a light source for the simulation, the light source can be modeled as a closed surface (typically a sphere) and the fibers modeled as being located within the surface and illuminated from the interior of the surface. Each point (or pixel) of the light probe image can be considered as a discrete light source. The omnidirectional image is preferably a high dynamic range image.

By simulating using different light probe images, a user can see how the fibers would appear under different illumination conditions. The set of different light probe images available for the user to choose from may include one or more of the following: indoor scenes, outdoor scenes, scenes from different parts of the world, scenes illuminated by natural light (sunlight), scenes illuminated by artificial light, and scenes containing a mixture of both artificial and natural illumination.

Preferably, the omnidirectional image is an image of a real physical scene captured by a real physical camera.

Preferably, the fibers comprise hair, more preferably human hair.

The synthetic image is preferably rendered as a high dynamic range image.

The method may further comprise displaying the synthetic image, preferably on a color-calibrated monitor. If the synthetic image is rendered as a high dynamic range image, the dynamic range of the image may be reduced for display. For example, an 8-bit version of the synthetic image may be displayed - in particular, if the display screen is not capable of displaying high dynamic range images.

As used herein, a step of "displaying" an image preferably comprises displaying it on a display screen - that is, providing control signals to a display screen, to control the display screen to show the image. Preferably, the display screen is color-calibrated, for consistently accurate color reproduction. In some circumstances, an image may be displayed by other technical means. For example, an image may be displayed by printing - that is the step of "displaying" may comprise providing control signals to a printer, to control the printer to print the image. The printer is preferably color-calibrated.

Preferably, the first set of fiber parameters is obtained by analyzing a sample of hair; and the step of modifying the first set of parameters comprises modifying at least one parameter related to a color of the hair, whereby the second set of parameters describes the person's hair with a modified color, wherein the method further comprises displaying the rendered synthetic image, to illustrate how the hair would appear if it had the modified color.

The method may further comprise using the synthetic image to specify or communicate to at least one person a desired hair color.

The method may further comprise formulating a hair dye composition, using the appearance of the hair in the synthetic image as a reference.

In conventional strategies for the formulation of hair dye compositions, specifying the intended color is a significant challenge. Typically, the desired color is specified relative to a color that was produced by an existing dye formulation. The specification will use descriptive language (such as "warmer") to define the color that the new dye is intended to produce. However, such descriptions are unavoidably subjective and vague. If a team of people is involved in the specification and dye formulation (as is usually the case), each person may have a different concept of the desired result. The consequence is that many iterations are needed - with dyes being formulated, tested, and rejected because they do not match the desired result (as understood by one or more members of the team). Essentially, the early attempts at formulation are wasted, because they are being used to refine the understanding of what is desired, rather than trying to achieve a well-defined goal. By using a photorealistic synthetic image to specify the target color, the problems of natural language specification and subjectivity are avoided. The synthetic image provides an objective target. All of the people in the team can see, understand, and agree on the goal that is desired, or continue modifying that goal until a consensus is reached. This can dramatically reduce the number of iterations when formulating dyes, thereby reducing the time and cost. The team of people can also be located remotely from one another, because the synthetic image can be transmitted electronically and displayed to each person on an individual color-calibrated monitor, if so desired.

Because the synthetic image is generated using a computational model of interactions between light and fibers (which is faithful to the real physical interactions between actual light and actual material hair fibers), the synthetic image can be natural looking and the color of the hair as it appears in the image can be physically realizable - at least under the illumination used in the simulation/rendering. A set of synthetic images can also be used to present the appearance of the modified hair fibers under a variety of different illumination conditions. This can allow the people specifying the color to verify that it will look attractive in different environments.

The method may further comprise obtaining head parameters for use with the model, which describe the positions of a plurality of hair fibers on a head, defining a hairstyle, the method comprising simulating, using the model, the head parameters, and the second set of fiber parameters, how light would interact with the modified fibers in the positions described by the head parameters.

The head parameters define a hairstyle - preferably including the position, orientation, and/or shape of each individual fiber on the head (or a part of the head). This may include at least 20,000 fibers, preferably at least 50,000 fibers, more preferably at least 75,000 fibers, to produce a realistic synthetic image. The head may be "virtual" - that is, not representing any real person's hair style - in particular, because of the difficulty of measuring the position of every individual hair on a human head. The head parameters may describe other features of the head, such as the appearance of a face, a skin color of the face or of a scalp, or the appearance of eyes, ears, or a mouth.

Also provided are one or more processor-readable storage devices containing processor-readable code for programming one or more processors to perform a method according to this aspect as summarized above.

In particular, there are provided one or more processor-readable storage devices containing processor-readable code for programming one or more processors to perform a method comprising the steps of: obtaining a first set of fiber parameters for a computational model of interactions between light and fibers, said first set of fiber parameters describing a plurality of real fibers; modifying the first set of fiber parameters, to produce a second set of fiber parameters describing a plurality of modified fibers; simulating, using the model and the second set of fiber parameters, how light would interact with the modified fibers; and rendering, based on the result of the simulation, a synthetic image showing the appearance of the modified fibers.

A storage device (or, equivalently, storage medium) may be non-transitory.

Also provided is an image processing apparatus comprising:
a memory; and
at least one processor adapted to:
   obtain a first set of fiber parameters for a computational model of interactions between light and fibers, said first set of fiber parameters describing a plurality of real fibers;
   modify the first set of fiber parameters, to produce a second set of fiber parameters describing a plurality of modified fibers;
   simulate, using the model and the second set of fiber parameters, how light would interact with the modified fibers;
   render, based on the result of the simulation, a synthetic image showing the appearance of the modified fibers; and
   store the rendered synthetic image in the memory.

The apparatus may further comprise a display screen, preferably a color-calibrated display screen. The processor is preferably further adapted to control the display screen to display the synthetic image.

In the image processing apparatus, the synthetic image may comprise a plurality of pixels corresponding to a respective plurality of spatial positions in a virtual image plane; the at least one processor may comprise at least one first processor in a first computer and at least one second processor in a second computer, the first computer and the second computer configured to be connected over a network; each processor may be adapted to simulate how light would interact with the modified fibers by simulating, for each of a plurality of rays of light arriving at each position, a journey of that ray from a light source to the position, said journey including one or more interactions with one or more of the modified fibers; each processor may be adapted to perform calculations in parallel with the other processor; and each processor may be adapted to simulate, for each position, the journeys of a respective different plurality of rays.

The image processing apparatus may further comprise a camera, for obtaining an image of the plurality of real fibers; and the at least one processor may be further adapted to automatically process the image to determine the first set of fiber parameters.

In particular, the at least one processor may be adapted to: process the image to determine a set of estimated fiber parameters; simulate, using the model and the estimated fiber parameters, how light would interact with fibers with the estimated parameters; compute an error metric comparing the result of the simulation with the content of the image; update the estimated parameters, based on the error metric; iterate the steps of simulating, computing, and updating, until the estimated fiber parameters converge to stable values; and determine the first set of fiber parameters based on the converged estimated fiber parameters.

According to another aspect there is disclosed a method for assisting a user to compare appearances of fibers, the method comprising:
providing a computational model describing the interaction of light with fibers;
obtaining a first set of fiber parameters for use with the model, said first set of fiber parameters describing a first plurality of fibers;
obtaining a second set of fiber parameters for use with the model, said second set of fiber parameters describing a second plurality of fibers;
simulating, using the model and the first set of fiber parameters, how light would interact with the first plurality of fibers, and rendering, based on the result of the simulation, a first synthetic image showing the appearance of the first plurality of fibers;
simulating, using the model and the second set of fiber parameters, how light would interact with the second plurality of fibers, and rendering, based on the result of the simulation, a second synthetic image showing the appearance of the second plurality of fibers; and
displaying the first synthetic image and the second synthetic image to the user.

This method can be used to assist the user to visualize the different appearances of different fibrous materials, or the different appearances of similar fibrous materials under different conditions. Because the synthetic images are created using a computational model of how light actually interacts with fibers, they can be photorealistic - a faithful approximation of how the fibers would appear in the real world. In this context, presenting two different synthetic images can provide a powerful way for the user to compare (subjectively) the two appearances.

The first plurality of fibers, described by the first set of fiber parameters, may be real fibers.

Optionally, the first set of fiber parameters is obtainable by physical measurement and analysis of real fibers. That is, the parameters may be derived from actual material fiber samples.

In this case, the first synthetic image illustrates how a plurality of fibers with the same parameters as the real fibers will appear. It allows the real fibers to be visualized in a virtual world, where - for example - the illumination can be defined arbitrarily. If the fibers are hair fibers, the first synthetic image may show how the fibers appear when their parameters are applied to a particular virtual hairstyle.

The second plurality of fibers, described by the second set of fiber parameters, may be real fibers.

Optionally, the second set of fiber parameters is obtainable by physical measurement and analysis of real fibers. That is, the parameters may be derived from actual material fiber samples.

Generally, the second plurality of fibers comprises different fibers from the first plurality of fibers.

In this case, both sets of parameters are derivable from real fibers and the two synthetic images can assist the user to compare the appearances of the two types of fibers. Since both sets of parameters describe real fibers, it would be possible - in principle - to compare the original real fibers directly. However, a virtual comparison may have several potential advantages. The original real fibers may be in different locations, preventing inspection "side-by-side" or immediately one after the other. Human memory can be subjective and unreliable and it is desirable that the appearances are seen close together (in space and time) to obtain meaningful, consistent results. Another potential advantage is that the display of the synthetic images and their comparison by a human user can be remote from any of the real fibers. For example, the images may be displayed to multiple users in different parts of the world, to collect a wide range of subjective assessments.

In some circumstances, the quantity of real fibers may be limited. For example, in the hair-care industry, dyes may be tested on small samples (tresses) of hair. It may be difficult for a user to get a good impression, from these small samples, of how a whole head of hair would appear when treated with the dye. Accordingly, the present method may comprise obtaining sets of fiber parameters from respective real dyed hair samples. The appearances of arbitrary number of fibers, in arbitrary hairstyles, or under arbitrary illumination conditions can then be simulated, and presented to the user in the form of synthetic images. This can give a realistic impression of how a whole head of hair would appear when dyed to the same color as the samples, without the time and expense of dyeing a large quantity of hair, or dyeing a real person's hair in place on the person's head.

The step of obtaining the second set of fiber parameters optionally comprises modifying the first set of fiber parameters, so that the second set of fiber parameters describes a plurality of modified fibers.

This can allow the user to compare the appearance of real fibers (for example, real hair) with the appearance of a modified version of those fibers.

Optionally, the modification of the first set of fiber parameters may represent a physical modification of the real fibers - for example, a treatment applied to the real fibers, such as a chemical treatment, particularly the application of a dye. Thus, the user may be able to compare the appearance of a current hair color with the appearance of a "virtual" hair color. This may assist the user in deciding whether or not to dye their hair and what color to dye it.

The method may further comprise using the second synthetic image to specify or communicate to at least one person a desired hair color.

Optionally: each set of parameters comprises at least one color parameter related to a color of the respective plurality of fibers; and the value of the at least one color parameter in the first set of parameters is different from the value of the at least one color parameter in the second set of parameters.

This means that the second plurality of fibers has a different color to the first plurality of fibers.

The method may further comprise receiving user input comprising a subjective assessment of whether the appearance of the first plurality of fibers in the first synthetic image and the appearance of the second plurality of fibers in the second synthetic image are the same or different.

Subjective assessments of whether fiber samples appear the same or different are important in many contexts. For example, in the hair care industry, when a dye composition is reformulated, it may be desirable that the new formulation delivers the same coloring results as the old formulation. It may be possible to obtain more reliable subjective assessments by presenting the appearance of the dyed hair to the user in the form of synthetic images, as discussed already above.

The method may further comprise receiving user input indicating which appearance is preferred by the user, between the first synthetic image and the second synthetic image.

Optionally, the user provides a subjective assessment of which of the two pluralities of fibers is more appealing to the user, based on the appearance of the first plurality of fibers in the first synthetic image and the appearance of the second plurality of fibers in the second synthetic image.

The method may further comprise using the preferred synthetic image to specify or communicate to at least one person a desired hair color. For example, the user may be a customer in a hair color consultation and the desired appearance may be a desired hair color. In another example, the user is a hair-care professional, and the desired appearance is used to specify a target color that a hair dye (or other treatment) is intended to produce.

The method optionally further comprises: adjusting the set of parameters for the preferred image, to produce an adjusted set of parameters describing a plurality of adjusted fibers; simulating, using the model and the adjusted set of fiber parameters, how light would interact with the plurality of adjusted fibers; and rendering, based on the result of the simulation, a further synthetic image showing the appearance of the plurality of adjusted fibers.

The further synthetic image showing the fibers with the adjusted parameters is preferably displayed to the user on a display screen.

The fibers are preferably hair fibers and adjusting the parameters may comprise adjusting the parameters in response to user feedback, so that the adjusted fibers more closely match an appearance that is desired by the user. This can enable the user to iteratively refine the specification of a desired appearance. The results of successive iterations may be compared on screen and/or the result of each iteration may be compared with a synthetic image illustrating the original appearance or a current real appearance.

The method optionally further comprises: obtaining first light source parameters for use with the model, which describe a first light source; and obtaining second light source parameters for use with the model, which describe a second, different light source; the method comprising: simulating, using the model, the first light source parameters, and the first set of fiber parameters, how light from the first light source would interact with the first plurality of fibers; and simulating, using the model, the second light source parameters, and the second set of fiber parameters, how light from the second light source would interact with the second plurality of fibers, whereby the first synthetic image illustrates the appearance of the first plurality of fibers under the first light source and the second synthetic image illustrates the appearance of the second plurality of fibers under the second light source.

Optionally, in this case, the first plurality of fibers and the second plurality of fibers are the same (and the first set of fiber parameters is identical to the second set of fiber parameters). Thus, the first and second synthetic images will show fibers with the same parameters, but under different illumination conditions.

The method optionally further comprises: obtaining first head parameters for use with the model, which describe the positions of a plurality of first hair fibers on a first head, defining a first hairstyle; obtaining second head parameters for use with the model, which describe the positions of a plurality of second hair fibers on a second head, defining a second hairstyle; the method comprising: simulating, using the model, the first head parameters, and the first set of fiber parameters, how light would interact with the first plurality of fibers in the positions described by the first head parameters; and simulating, using the model, the second head parameters, and the second set of fiber parameters, how light would interact with the second plurality of fibers in the positions described by the second head parameters.

Optionally, in this case, the first plurality of fibers and the second plurality of fibers are the same (and the first set of fiber parameters is identical to the second set of fiber parameters). Thus, the first and second synthetic images will show fibers with the same parameters, but arranged in different hairstyles.

The first synthetic image and the second synthetic image may be displayed concurrently. For example, the images may be displayed side by side or one above the other.

Alternatively or in addition, the first synthetic image and the second synthetic image may be displayed consecutively in time.

For example, the images may be displayed one after the other, in the same position.

In each case, the images are preferably displayed on the same display screen.

Also disclosed are one or more processor-readable storage devices containing processor-readable code for programming one or more processors to perform a method according to this aspect, as summarized above.

Also disclosed is an image processing apparatus comprising:
a memory;
a display screen; and
at least one processor adapted to:
   obtain a first set of fiber parameters for a computational model of interactions between light and fibers, said first set of fiber parameters describing a first plurality of fibers;
   obtain a second set of fiber parameters for the computational model, said second set of fiber parameters describing a second plurality of fibers;
   simulate, using the model and the first set of fiber parameters, how light would interact with the first plurality of fibers, and render, based on the result of the simulation, a first synthetic image showing the appearance of the first plurality of fibers;
   simulate, using the model and the second set of fiber parameters, how light would interact with the second plurality of fibers, and render, based on the result of the simulation, a second synthetic image showing the appearance of the second plurality of fibers; and
at least one of:
   store the rendered first and second synthetic images in the memory; and
display the first synthetic image and the second synthetic image on the display screen.

Although the optional features of each aspect have been summarized above separately, the features of one aspect may also be combined with features of the other aspect.

### BRIEF DESCRIPTION OF THE DRAWINGS

Examples of the invention will now be described in detail with reference to the accompanying drawings, in which:
Fig. 1 shows an image processing apparatus for synthesizing an image of fibers;
Fig. 2 is a flow-chart illustrating a method of synthesizing an image of fibers;
Fig. 3 shows an apparatus for measuring the optical properties of a sample of fibers;
Fig. 4 is a flow-chart illustrating a method of measuring the optical properties of fibers;
Fig. 5 is a flow-chart illustrating a method of synthesizing an image of fibers using parallel computing; and
Fig. 6 is a flow-chart illustrating a method for assisting a user to compare appearances of fibers.

### DETAILED DESCRIPTION OF THE INVENTION

As used herein, the term optically correct or photorealistic refers to an image which accurately portrays the interaction of visible electromagnetic radiation with a fibrous structure of particular optical properties.

As used herein the term color correct refers to an image which accurately portrays a fibrous structure of particular optical properties illuminated by a visible electromagnetic radiation source having a particular emissive spectrum.

As used herein the term fibrous structure refers to any structure comprised of discrete strands or fibers. Fibers may be artificial or natural fibers. In particular the term may be used to refer to an array of strands of keratinous materials. Keratinous fibers may be selected from wool, fur, silk, hair and mixtures thereof; preferably from mammalian hair; more preferably from human hair. Hair may be living hair (that is, on a living body) or non-living hair (that is, in a wig, hairpiece, or other aggregation of non-living keratinous fibers). Hair may be from Caucasian, Asian, African, Afro-Caribbean origins or combinations of these ethnic types. Hair may be selected from untreated hair, treated hair, and mixtures thereof. Treated hair may be selected from artificially-colored hair, bleached hair, permanently-waved hair, and mixtures thereof.

The fibers may have an average diameter from about 10 to about 200 microns, preferably from about 30 to about 150 microns, more preferably about 50 to about 120 microns.

As used herein, "high" dynamic range refers to images with a bit-resolution of more than 8 bits per pixel per color channel or more than 24 bits per pixel in total for a color image. Ordinary digital images typically use 8 bits per pixel, per color channel and therefore 24 bits per pixel to represent a conventional color image. Preferably, a high dynamic range image has at least 10 bits per pixel per color channel.

As used herein, light refers to electromagnetic radiation in the visible spectrum.

As used herein, an omnidirectional image is one whose visual field includes 360 degrees in a first plane and at least 180 degrees in a second, orthogonal plane. This means that the field of view is effectively at least a hemisphere. Preferably, an omnidirectional image has a visual field including 360 degrees in both the first and second planes, such that the field of view is effectively a sphere.

As used herein, color-calibrated means that the color temperature, brightness, and color space is defined and then calibrated versus at least one reference color.

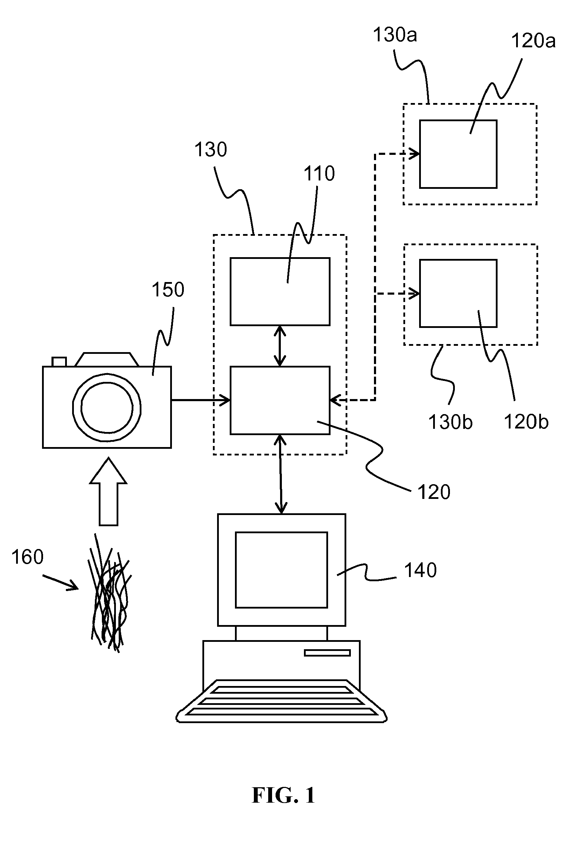

Fig. 1 shows an image processing apparatus for synthesizing an image of fibers. The apparatus comprises a computer 130; a display screen 140; and a camera 150. The computer 130 comprises a memory 110 and a processor 120. The processor 120 and memory 110 are coupled to one another and configured to communicate with one another (for example, using an internal bus of the computer 130). The display screen 140 and the camera 150 are coupled to the computer 130 (for example, using wired or wireless connections) and configured to communicate with the processor 120. The apparatus further comprises two additional computers: a first computer 130a and a second computer 130b. These additional computers are coupled to the computer 130 via a network and are configured to communicate with the processor 120 across that network. Each computer 130a, 130b comprises a respective processor 120a, 120b. As will be explained in greater detail below, the two computers 130a and 130b may be used to assist in synthesizing images of fibers by implementing parallel processing. The camera 150 is configured to obtain an image of a plurality of real fibers 160 and to communicate this image to the processor 120 of the computer 130. The display screen 140 is configured to receive from the processor 120 control signals to control the display screen to display a synthesized image of fibers. The display screen 140 is preferably color-calibrated.

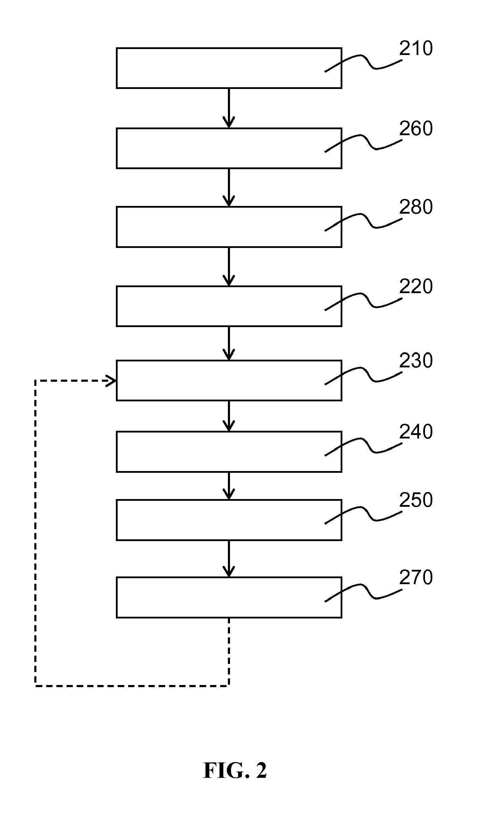

Fig. 2 is a flow-chart illustrating a method of synthesizing an image of fibers, implemented by the apparatus of Fig. 1. In the example of Figs. 1 and 2, the fibers in question comprise human hair. According to the exemplary method, a computational model describing the interaction of light with fibers is provided (step 210). This model may be stored in the memory 110 and provided to the processor 120 during an initialization phase of the method. In step 220, the processor 120 obtains a first set of fiber parameters for use with the model. The first set of fiber parameters describes a plurality of real fibers - namely, the sample of real human hair 160. Ways of obtaining the fiber parameters will be described in greater detail below. In step 230, the processor 120 modifies the first set of fiber parameters to produce a second set of fiber parameters. The second set of fiber parameters describes a modified version of the real hair fibers 160. In this example, the first set of parameters includes at least one parameter relating to a color of the hair fibers 160. This is modified in the second set of parameters, such that the second set of parameters describes a modified version of the hair fibers 160 having a different color. This can be used to model the effect of a chemical treatment on the fibers. For example, the second set of parameters can model the effect of bleaching or dyeing the hair fibers 160. The parameters may be modified automatically by the processor, or they may be modified in response to user input - for example, user input that indicates the chemical treatment whose effect the user wishes to model, or user input that indicates the way in which it is desired to modify the parameters. In one example, the system provides the user with a user interface to modify the parameters and the user inputs modified parameters using this interface. In step 240, the processor 120 simulates how light would interact with the modified fibers. This comprises calculations using the computational model together with the second set of fiber parameters. Based on the result of the simulation 240, the processor 120 renders a synthetic image showing the appearance of the modified fibers (step 250). The processor 120 may store the rendered image in the memory 110. Alternatively or in addition, it may display the rendered synthetic image on the display screen 140, in step 270.

Optionally, a user may inspect the displayed synthetic image. If the user is satisfied with the appearance of the modified fibers in the synthesized image, the user may use the image to communicate the appearance of the modified fibers to at least one other person as a desired appearance. For example, the user may be a customer in a hair salon and may use the synthetic image to communicate, to a hair-care professional, the color that the user wishes his/hair to have after bleaching and/or dyeing. In this case, the original real hair fibers 160 represented by the first set of fiber parameters would be a sample of the user's own hair in its current condition.

In another example, the user may be a hair-care professional. The real hair fibers 160 (which are described by the first set of fiber parameters) may be a standard sample (tress) of hair that has been dyed using an existing dye composition. The hair care professional may use the synthetic image to communicate, to a dye-formulation specialist, a hair color that the professional wishes to achieve with a new dye (that is yet to be formulated). This may assist the formulation specialist to understand the desired result of the new dye composition. The formulation specialist may then formulate the new hair dye composition using the appearance of the modified hair fibers in the synthetic image as a reference or target.

Optionally, other parameters may be used with the computational model to generate the synthetic image, in addition to the second set of fiber parameters. Preferably, the processor 120 obtains light source parameters for use with the computational model, in step 260. The light source parameters describe a light source, which is used to illuminate the modified fibers in the virtual world of the simulation. Preferably, the light source parameters comprise an omnidirectional image of a real scene, also known as a light probe image. Preferably, the processor 120 also obtains head parameters for use with the model, in step 280. The head parameters describe the positions of a plurality of hair fibers on a head, defining a hair style. In the example of Fig. 2, the position, orientation, length, and shape of each individual hair on the (virtual) head is defined by the head parameters. The optical characteristics of the hair fibers are described by the fiber parameters and the light illuminating the fibers on the head is determined from the light source parameters. The computational model defines how all of these parameters are combined, to simulate the interaction of the light with the fibers and render a resultant synthetic image. Thus, the computational model captures the most important physical characteristics that affect the appearance of hair fibers in the real world. The fiber parameters, light source parameters, and head parameters define a numerical representation, in a virtual world, for simulating the same physical processes that occur in the real world to form a real image of a head of hair.

Optionally, after the synthetic image is displayed in step 270, the user may decide that he/she is not yet satisfied with the appearance of the modified hair fibers. In this case, the user may provide user input to the processor 120, in response to which the processor further modifies the fiber parameters. Essentially, as shown by the dashed line in Fig. 2, the method proceeds to step 230 again and the steps of simulating 240 and rendering 250 a synthetic image are performed again. The method can proceed in an iterative fashion, in this way - successively refining the fiber parameters, until the user is satisfied with the appearance of the modified fibers in the synthetic image.

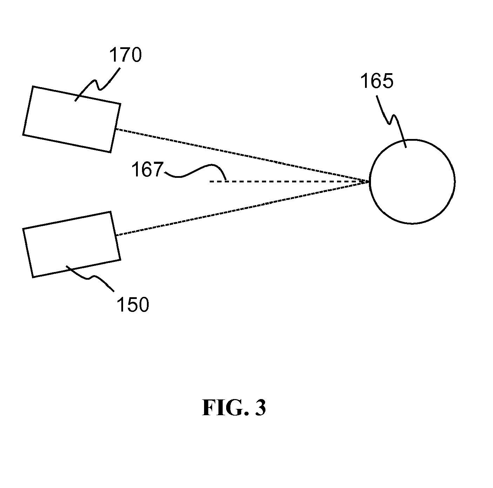

Fig. 3 illustrates an exemplary apparatus for measuring the optical properties of a sample of fibers, such as the hair fibers 160 in Fig. 1. The apparatus comprises a material holder 165 comprising a curvilinear surface; a collimated light source 170; and the camera 150. In this example, the material holder 165 comprises a cylinder. Therefore, the curvilinear surface is cylindrical. The hair fibers 160 are wrapped around the circumference of the cylinder, such that each fiber is disposed in a plane substantially perpendicular to the axis of the cylinder. The incident light rays from the collimated light source 170 and the optical axis of the camera 150 lie in substantially the same plane as a surface normal 167 of the curved surface of the cylinder. For example, they preferably lie within 0.5 degrees of the plane. This plane is perpendicular to the axis of the cylinder; thus, the collimated light, the surface normal and the optical axis of the camera may share the same plane as some of the hair fibers. The light source 170 illuminates the material holder 165. An angular offset between an axis of the collimated light source 170 and the optical axis of the camera 150 is less than about 5 degrees, in the same plane as the surface normal of the curvilinear surface of the material holder 165. Preferably, the offset between the two axes is less than about 3 degrees. Preferably, either the camera 150 or the light source 170 is disposed such that its axis is normal to the curvilinear surface of the material holder, with the other axis disposed at an angular offset as described above. Alternatively, each of the two axes may be disposed at angle to the normal to the curvilinear surface that is about half of the chosen angular offset. As an example, each of the two axes may be disposed with an angle of 2.5 degrees between the axis and the normal to the curvilinear surface. The divergence angle of the collimated light may be less than about 0.5 degrees. The luminance of the light source in the area where the target material is mounted preferably does not vary by more than 5% of the average luminance in this area. The image capture element and illumination source may each be aligned to within about 5 degrees, preferably within about 1 degree, more preferably within about 0.2 degrees, of the plane including the surface normal of the curvilinear surface of the material holder.

A Xenon High Pressure light source may be used to illuminate the fibers and material holder. The 150W Xenon arc lamp Model: 6255 Oriel Instruments available from LOT Quantum Design GmbH (Germany) is an exemplary light source. The light source may be a collimated D55 simulator. D55 corresponds approximately to midday sun light in Western Europe / Northern Europe; hence, it is also called a daylight illuminant. The material holder may be fabricated from any suitable material including wood, metal, glass, polymers, or composite materials. The material holder may comprise a comb or other fiber-separating element, to enable the fiber sample to be arrayed upon the material holder with the fibers separated and aligned upon the curvilinear surface.

The camera preferably comprises a high dynamic range digital camera. An exemplary camera, is the TXG50c available from the Baumer Group, of Frauenfeld, Switzerland, and having a dynamic range of 12 bits for each of the Red, Green and Blue channels. A digital camera of lower dynamic range (for example, 8 bits per channel) may be used, by capturing multiple images at different exposures and combining them into a single high dynamic range image. The image may be smoothed by calculating an average value for each row of pixels in the image and subsequently altering the value of each pixel as necessary to reduce the difference between the value of that particular pixel and the average value for the row of pixels.

The sample may comprise from about 2 to about 10000, preferably from about 10 to about 5000, more preferably from about 100 to about 2000, fibers. In practice, a sample of fibrous material, such as hair, is disposed in an aligned array upon the curvilinear surface of the material holder. The arrayed fibers may be disposed in multiple layers upon the surface or in a single layer. Preferably, the fibers are disposed in multiple layers because this may allow the effects of light-scattering by multiple fibers (global illumination) to be captured more accurately.

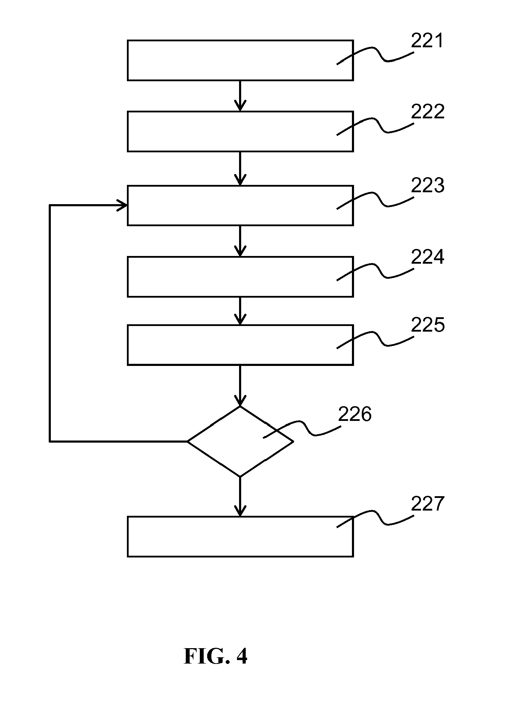

Fig. 4 is a flow-chart illustrating a method for measuring the optical properties of fibers, performed by the apparatus of Figs. 1 and 3. In step 221, the camera 150 captures an image of the hair fibers 160 wrapped around the material holder 165. In step 222, the processor 120 processes the image to determine an initial set of estimated fiber parameters. The method then follows an "analysis by synthesis" approach. In step 223, the processor 120 simulates, using the computational model and the initial estimated fiber parameters, how light would interact with a plurality of fibers having those initial estimated parameters. In step 224, the results of this simulation are compared with the image captured by the camera 150. An error metric is computed, characterizing the difference between the simulated results and the real image. In step 225, the processor 120 updates the estimated fiber parameters, based on the error metric. The processor then tests, in step 226, whether the estimated fiber parameters have converged to stable values yet. If the estimated fiber parameters have not yet converged sufficiently, the steps of simulating 223, computing the error metric 224, and updating the parameters 225 are repeated. The iterations continue until the estimated fiber parameters converge - that is, until the previous set of parameters and the updated parameters after step 225 are sufficiently similar. Convergence can also be determined by detecting when the magnitude of the error metric falls below a predefined threshold. When the parameters have converged, the method proceeds to step 227 and the first set of fiber parameters, describing the hair fiber sample 160, are determined by setting them equal to the converged estimated fiber parameters.

One suitable method for estimating and updating fiber parameters is described in the paper Zinke et al. (Arno Zinke, Tomas Lay, and Anton Andriyenko, "A practical approach for photometric acquisition of hair color", ACM transactions on graphics, Volume 28, No. 5, Article 165, December 2009). The set of fiber parameters captures the most important optical properties of the hair fibers. It comprises an "optical fingerprint" of the hair. The set of fiber parameters preferably includes the parameters described below. These parameters are discussed in greater detail in Zinke et al. A suitable computational model for use with these parameters, known as the Bidirectional Fiber Scattering Distribution Function (BFSDF), is described in Zinke and Weber (Arno Zinke and Andreas Weber, "Light Scattering from Filaments", IEEE Transactions on Visualization and Computer Graphics (Volume: 13, Issue: 2), pages 342-356, March-April 2007). Briefly, this computational model locally approximates a fiber by its minimum enclosing cylinder.

Three absorption coefficients *σ*ₐ can be used to describe how light at different wavelengths is absorbed by the fibers. One coefficient is provided for each of the red, green, and blue channels. The coefficient for each color channel describes how much light of that color is absorbed (and therefore not scattered) by the fiber. The coefficients are labeled Absorption Red; Absorption Green; and Absorption Blue. Each of these three parameters has units of the inverse of the radius of the fiber (radius⁻¹).

A good approximation for the scattering of light by the fibers is obtained by considering the first three scattering modes. A first backward scattering component describes how incident light is reflected from a first surface of the enclosing cylinder. This is called the "R" (Reflection) component. A first forward scattering component describes how incident light is transmitted through the first surface of the cylinder and also through a second surface of the cylinder. This is called the "TT" (Transmission-Transmission) component. A second backward scattering component describes how incident light is transmitted through the first surface of the cylinder, reflected from the second surface of the cylinder, and transmitted through a third surface of the cylinder. This is called the "TRT" (Transmission-Reflection-Transmission) component. For a perfect dielectric fiber, specular scattering would result in a cone of scattered light, for each scattering mode. For hair fibers, in particular, the tiled surface structure of the hair fibers is believed to lead to shifted specular cones, compared with the perfect dielectric fiber. Consequently, for each of the three scattering components, there is preferably a parameter α describing the longitudinal shift of the specular cone. Furthermore, due to surface roughness and inhomogeneity inside the fiber, the scattering distribution is blurred, compared with the ideal dielectric fiber. To capture this effect, the plurality of fiber parameters can also include a longitudinal width parameter β, for each of the three scattering modes. This gives six parameters, labeled: Long Shift R (*α*_{R}), Long Shift TT (*α*_{TT}), Long Shift TRT (*α*_{TRT}), Long Width R (*β*_{R}), Long Width TT (*β*_{TT}), and Long Width TRT (*β*_{TRT}). Each of these six parameters is an angle, having units of degrees. A scaling factor *s*_{R}, also known as Scale R, can also be included, which determines the strength of the R-component. This parameter is dimensionless.

A diffuse reflection component can also be included. A weight parameter, the diffuse fraction d, gives the fraction of diffusely scattered light. A spherical reflectance *r*_{d} is provided for each of the color channels, giving three parameters labeled: Diffuse Reflectance Red, Diffuse Reflectance Green, and Diffuse Reflectance Blue. These are also dimensionless parameters.

Parameters values in the following ranges have been found to yield acceptable representations of fibrous structures:

| **Parameter** | **Suitable Range** |
|---|---|
| Absorption Red | 0.00805 to 2.96 |
| Absorption Green | 0.018365 to 2.9613 |
| Absorption Blue | 0.031964 to 2.984 |
| Long Shift R | (-8.3837) to (-0.9615) |
| Long Shift TT | (-0.33319) to 3.8045 |
| Long Shift TRT | (-0.99956) to 11.4136 |
| Long Width R | 1.4976 to 12.4241 |
| Long Width TT | 1.6076 to 15.3835 |
| Long Width TRT | 4.1421 to 35.5172 |
| Scale R | 0.60002 to 0.99999 |
| Diffuse Fraction | 0.00225 to 0.28391 |
| Diffuse Reflectance Red | 0.20935 to 1.124 |
| Diffuse Reflectance Green | 0.083714 to 1.0391 |
| Diffuse Reflectance Blue | 0.013692 to 1.0381 |

As will be apparent to those skilled in the art from the explanation above, this plurality of fiber parameters includes parameters related to absorption and parameters related to scattering. In this example, the parameters related to the color of the hair comprise the three absorption coefficients and the three diffuse reflectances. If these color-parameters are modified (in step 230 of the method of Fig. 2) then the modified fibers pictured in the synthetic image will have a different color to the original hair fiber sample 160.

The parameters discussed above can be allowed to vary, to describe different fibers (in particular, hair fibers), according to the computational model. However, there may also be some fixed parameters, which are never varied. For example the refractive index of the fibers may be assumed to be always constant. Other examples of parameters that may be fixed are described in the paper by Zinke et al.

The second set of fiber parameters, used with the computational model in the simulation step 240, may describe average properties of the plurality of modified fibers. However, real hairs on a person's head are not all identical. There is natural variation in the optical properties between different positions on the same hair fiber and between different fibers. An image rendered using only the average fiber parameters may therefore appear too homogenous and consequently unnatural. There are several possible ways to address this. In one example, individual fibers in the virtual hair style (which is defined by the head parameters) may be described by combining the average fiber parameters with a varying component that is unique to each individual fiber, or unique to a particular position along the fiber. The varying component may comprise random noise, such as may be generated using a pseudo random number generator. This approach can be used to give the synthetic image a more natural appearance, without adding to complexity by estimating and storing fiber parameters for many thousands of individual hair fibers. Alternatively or in addition to random variations, there may be systematic variations, both within and between fibers. For example, fibers may be lighter at the root than over the rest of the fiber, modeling grey hair that has been dyed previously but has since grown, revealing roots that have their natural grey appearance. In another example, fibers may be darker at the root, modeling hair that has been bleached previously, but has since grown, revealing roots that have their natural darker appearance. It may also be advantageous for the fiber parameters to define a systematic change in lightness from the front to the back of the head. Natural hair is usually lighter towards the top and front of the head and darker towards the back. These variations can be modeled by providing fiber parameters including at least one parameter that has a different value for different places along the length of the same fiber and/or a different value for different fibers at different positions on the head.

The interactions of light with the fibers may be simulated and the synthetic image rendered using a Monte Carlo path tracing algorithm. This traces the paths of individual rays of light from a light source (defined by the light source parameters) to a position in a virtual image plane corresponding to a pixel of the synthetic image. Along its journey, each ray of light interacts with one or more of the fibers. The optical properties of the fibers are specified by the set of fiber parameters and their positions in the virtual hair style are specified by the head parameters. At each interaction with a fiber, a ray of light may be absorbed or scattered in one of several ways (as discussed above), with a probability distribution that is defined by the computational model. The implementation of a Monte Carlo path-tracing algorithm will be within the capability of those skilled in the art.

As will be understood, the rays of light are "virtual" rays. They do not exist in the real world, only in the calculations performed in the simulation. Each ray of light constitutes a "sample". The quality of the rendered image typically depends on the number of samples per pixel. Preferably the simulation incorporates a global illumination model - that is, a model which includes mutual scattering of light between different objects in the scene (in particular, scattering of a single ray by multiple fibers). Alternatively, the simulation may use a ray-tracing algorithm. Ray-tracing algorithms typically do not incorporate global illumination, only direct illumination.

Optionally, the number of rays (that is, the number of samples) simulated for each pixel is dependent on the fiber parameters. In particular, the number of rays/samples per pixel is preferably greater for lighter colored fibers and lesser for darker colored fibers. This is based on the observation that, for light-colored fibers, the effect of multiple scattering (where a light-ray interacts with multiple fibers before arriving at a pixel) is more significant than for dark-colored fibers. To obtain a similarly accurate representation of light-colored fibers, therefore, may require a proportionally greater number of rays to be considered than for dark-colored fibers.

The total number of samples to be calculated may be defined before the start of the simulation. The simulation is "completed" when this predefined number of samples has been calculated. The number of samples is preferably chosen according to the desired quality of the rendered image. In principle, the accuracy of the simulation continues to increase indefinitely, as additional samples are calculated and combined. However, in practice, there will be no perceptible improvement in quality, after some finite number of samples. To a user viewing the synthetic image, the quality will not appear to improve, even if more samples are added, beyond this finite number. The predefined number of samples may be chosen so that it approximates this finite, "sufficient" number.

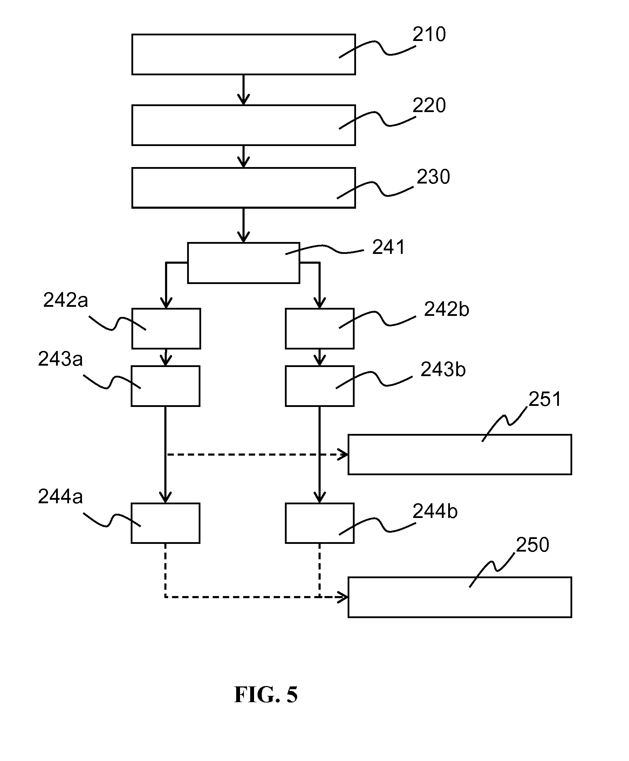

Fig. 5 is a flow-chart illustrating a method of synthesizing an image of fibers, using parallel computing. This is based on the flow-chart of Fig. 2 but, for simplicity, step 260 (obtaining light source parameters) and step 280 (obtaining head parameters) have been omitted. Step 210 (providing a computational model); step 220 (obtaining a first set of fiber parameters); and step 230 (modifying those fiber parameters) are the same as the corresponding steps in the method of Fig. 2 and will not be described further here. The parallel calculations are performed by the processor 120a of the first computer 130a and the processor 120b of the second computer 130b, under the control of the processor 120 of the computer 130. In step 241, the parallel calculations are initialized by the processor 120. This comprises dividing the simulation task between the first processor 120a and the second processor 120b. In particular, the processor 120 generates a first seed for the first processor 120a and a second different seed for the second processor 120b. Each seed will be used by the respective processor in a random number generator that generates samples according to the Monte Carlo path-tracing algorithm. Because the seeds are different, each processor 120a, 120b will generate a different set of samples. Each sample traces the path of a ray of light from a light source to a pixel in the synthetic image, via one or more interactions with the plurality of fibers (in the virtual world being simulated). The processor 120 communicates the seeds to the respective processors 120a and 120b via a network, indicated by dashed arrows in Fig. 1.

In step 242a, the first processor 120a receives the first seed from the processor 120; initializes a random number generator using the first seed; and determines a first ray to simulate using the random number generator and a Monte Carlo algorithm. The first processor 120a then simulates the path of this first ray. In step 243a, the first processor 120a determines a second ray to simulate - again, using the random number generator and the Monte Carlo algorithm. It also simulates the path of this ray. The processor 120a proceeds in this way, generating samples according to the Monte Carlo algorithm, and simulating the path of rays until it has simulated the paths of a predetermined number of rays for every pixel in the synthetic image. The final ray simulated is indicated in Fig. 5 by step 244a.

In parallel with these calculations by the first processor 120a (that is, at the same time that these calculations are being performed), the second processor 120b performs a different set of calculations. In step 242b, the second processor 120b receives the second seed from the processor 120, via the network; initializes a random number generator using the seed; and determines a first ray to simulate using the random number generator and a Monte Carlo algorithm. The second processor 120b then simulates the path of this ray. Next, in step 243b, the processor 120b generates and simulates a second light ray in a similar way. The second processor 120b proceeds in this way until it has calculated a predetermined number of samples for every pixel in the synthetic image. The final sample calculated by the second processor 120b is indicated in step 244b in Fig. 5. Note that it is not necessary that each of steps 242a, 243a, and 244a occurs at exactly the same time as the respective steps 242b, 243b, and 244b. The calculations performed by the first processor 120a are substantially independent of the calculations performed by the second processor 120b.

After the first processor 120a and the second processor 120b have calculated the assigned number of samples per pixel, for each pixel in the synthetic image, all of the samples are combined, by the processor 120, to render the synthetic image (step 250). Combining the samples may comprise calculating, for each pixel, a sum of the contributions of each sample to the pixel.

In the above example, the division of labor between the first computer 130a and the second computer 130b was based on each computer calculating different samples in the Monte Carlo path-tracing algorithm. In this example, each computer 130a, 130b (respectively processor 120a, 120b) calculated samples for every pixel in the synthetic image. Other strategies to parallelize the calculations are also possible and these may be used as alternatives or in addition to the strategy described above. For example, each computer 130a, 130b may be assigned the task of calculating all of the samples for a certain pixel or a certain group of pixels. Each computer 130a, 130b may be responsible for calculations associated with a respective portion of the synthetic image.

In one example, each processor 120a, 120b, comprises two or more cores. The first computer 130a may be assigned the task of calculating a certain number of samples for every pixel in the synthetic image (as discussed previously above). It may assign to each core in the processor 120a a task of calculating samples for a respective sub-group of pixels. That is, the simulation task may be divided between the computers 130a, 130b on the basis of samples and may be divided between the cores of a given processor 120a, 120b, on the basis of regions of pixels. Other strategies for parallel implementation may be appropriate depending upon the application.

Optionally, intermediate results of the simulation may be rendered while the simulation is still continuing. Referring again to Fig. 5, in step 251, the processor 120 renders a preliminary synthetic image and displays it on the display screen 140. This preliminary image is based on the samples that have been calculated so far by the processors 120a and 120b (in steps 242a, 243a, 242b, and 243b). Here, it is assumed that several samples have been calculated for each pixel before the rendering of the preliminary synthetic image.

Displaying a preliminary synthetic image (as in step 251) can enable a user to assess initial results of the simulation. The preliminary synthetic image generally appears as a noisy image. As more samples are calculated, the noise reduces, and the image resolves to a clearer one. The rendering and display of a preliminary image in step 251 therefore provides progressive rendering. Several preliminary images may be rendered and displayed to the user as the simulation proceeds, with successively increasing image quality. The user can get an early impression of the appearance of the modified fibers, from a preliminary synthetic image rendered in this way. If the user decides that this appearance does not match what he/she desired, then the simulation can be interrupted. Based on user input, the processor 120 further modifies the second set of fiber parameters to produce a third set of fiber parameters describing a plurality of further modified fibers. The simulation can then restart using these parameters. In this way, the system can shorten the time needed for each iteration (see the dashed line in Fig. 2) so that the user can achieve a desired appearance of the fibers, faster. Note that, although the progressive rendering has been described in the context of Fig. 5, it is not essential that it is performed in conjunction with a parallel implementation. Progressive rendering can also be used with non-parallel implementations.

Computers 130a and 130b that run the linux operating system may be preferred for parallel implementations.

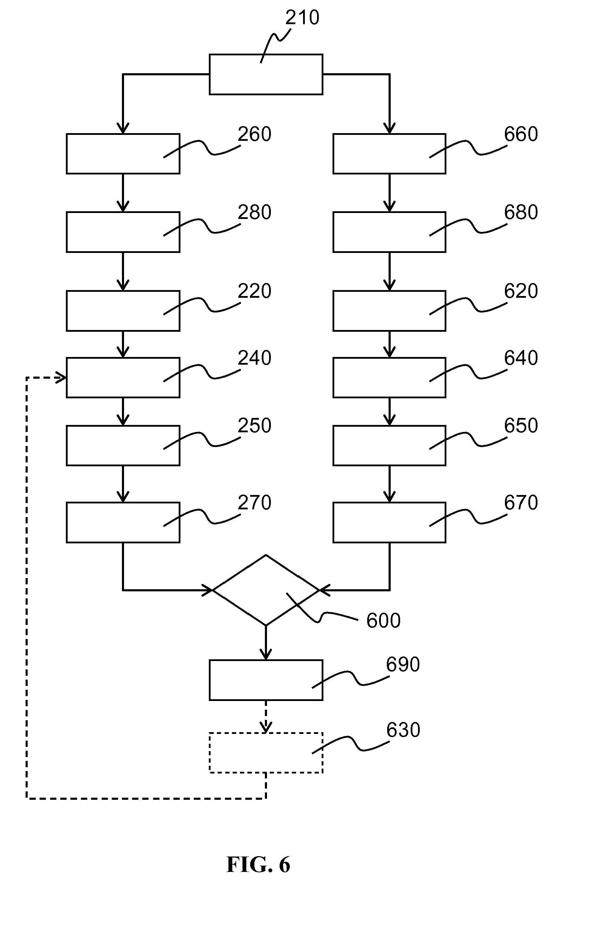

Fig. 6 is a flow-chart illustrating a method for assisting a user to compare the appearances of fibers. This method can be implemented by the apparatus of Fig. 1. In step 210, a computational model is provided to the processor 120. This model describes the interaction of light with fibers. In step 220, the processor 120 obtains a first set of fiber parameters for use with the model. These parameters describe a first plurality of fibers. In step 240, the processor 120 simulates how light would interact with this first plurality of fibers. Next, in step 250, the processor 120 renders a first synthetic image showing the appearance of the first plurality of fibers. The rendering is based on the result of the simulation. Steps 210, 220, 240, and 250 are essentially the same as those described earlier with reference to Fig. 2. However, in the method of Fig. 6, the first set of fiber parameters need not describe real fibers - the first set of fiber parameters may or may not be derivable from any real physical fibers, in general.

A similar sequence of steps is performed to render a second synthetic image showing the appearance of a second plurality of fibers. In step 620, the processor 120 obtains a second set of fiber parameters for use with the model. This second set describes the second plurality of fibers. In step 640, the processor 120 simulates, using the model and the second set of fiber parameters, how light would interact with the second plurality of fibers. It renders (in step 650) a second synthetic image, based on the result of the simulation, showing the appearance of the second plurality of fibers. These steps 620, 640, and 650 are substantially similar to the corresponding steps 220, 240, and 250 and will not be described in further detail.

In step 270, the processor 120 controls the display screen 140 to display the first synthetic image. Likewise, in step 670, the processor 120 controls the display screen 140 to display the second synthetic image. In this way, both synthetic images are displayed to the user. The user can compare the synthetic images (step 600) and can provide user input to the processor 120 in response to the comparison. In step 690, the processor receives this user input. The input may be received via a user input device. Suitable user input devices will be known to those skilled in the art and may include (without limitation): a keyboard, a mouse or other pointing device, a touch screen, microphone (for voice input), camera (for gesture input), or any other sensor or transducer capable of responding to user interaction.

How the processor responds to the user input may depend on the contents of the synthetic images and the purpose for which the images are being compared. In one example, the first plurality of fibers and the second plurality of fibers both comprise real fibers. These may be two samples of hair which have been treated by two different chemical treatments - for example, an old dye composition and a newly formulated dye composition. The purpose of the comparison may be to determine whether the hair dyed with the new dye composition has the same appearance as the hair dyed with the old composition. In this example, the step 690 of receiving user input may comprise receiving a subjective assessment of whether or not the first and second pluralities of fibers in the respective synthetic images appear the same (to the user).

In another example, one plurality of fibers may be real fibers and the other plurality of fibers might not be real. For instance, the second plurality of fibers may represent a plurality of modified fibers, as in the method of Fig. 2, above. In this case, the purpose of the comparison may be to determine whether the user prefers the appearance of the real fibers (in the first synthetic image) or the appearance of the modified fibers (in the second synthetic image). In this example, the step 690 of receiving user input may comprise receiving an indication of which of the two appearances is preferred by the user. The user may decide that the preferred appearance is more desirable but not yet fully acceptable. In this case, the processor may adjust the fiber parameters associated with the chosen synthetic image (step 630). It may then simulate 240, render 250, and display 270 a further synthetic image showing the appearance of the fibers having these further adjusted parameters. The method may proceed iteratively in this way, as shown by the dashed line in Fig. 6. This dashed line indicates that the method proceeds from step 630 to step 240. However, as will be clear to those skilled in the art, the method may proceed to step 240 or step 640, depending on which of the previous two synthetic images was preferred by the user.

In still another example, neither of the two pluralities of fibers may be representative of real physical fibers. For example, each set of fiber parameters may be obtained by measuring the parameters of some real fibers and then modifying those parameters in two different ways. For instance, each set of parameters may be intended to model the effect of a respective different chemical treatment applied to the original hair fibers, such as treatment by two different dyes, resulting in two different hair colors. (The colors may differ in their lightness, hue, chroma, and/or saturation, as discussed earlier above.) Again, the user may indicate which of the two resulting synthetic images he/she prefers. The preferred image may be used to specify the desired appearance of the user's hair to a hairdresser or colorist. Alternatively, the fiber parameters associated with the preferred synthetic image may be further adjusted in response to user feedback, to achieve an appearance in the synthetic image that more closely matches the user's wishes. Typically, the method would proceed iteratively in this way, until the user is satisfied with the appearance illustrated in one of the synthetic images.

As mentioned already in the context of Fig. 2, the method may include the processor 120 obtaining (in step 260) first light source parameters for use with the model, describing a first light source. It may also comprise the processor 120 obtaining first head parameters for use with the model, describing the configuration of a plurality of first hair fibers on a first head, defining a first hair style (step 280). These additional parameters may be used together with the first set of fiber parameters, when simulating how light would interact with the first plurality of fibers. Similarly, the method may comprise the processor 120 obtaining second light source parameters describing a second light source (step 660). It may further comprise the processor 120 obtaining second head parameters describing a plurality of second hair fibers forming a second hair style on a second head (step 680).

In general, at least one of the three sets of parameters (fiber parameters, light source parameters, and head parameters) will be different in some respect. If the first light source parameters are different (in value) from the second light source parameters, the first head parameters may be the same as the second head parameters, and the first set of fiber parameters may be the same as the second set of fiber parameters. In this case, the first and second synthetic images will show the appearance of the same hair, with the same hair style, but under differing illumination conditions. In another example, the first and second light source parameters and the first and second sets of fiber parameters may be identical, but the first head parameters may be different from the second head parameters. In this case, the synthetic images will illustrate the appearance of two different hairstyles, under the same illumination conditions and with hair fibers having the same optical properties (particularly, the same color).

In steps 270 and 670, when the two synthetic images are displayed for comparison by the user, they may be displayed on the display screen 140 at the same time - for example, side by side or one above the other - or they may be displayed in sequence, with either one being displayed before the other. It is not essential that the two synthetic images are displayed on a single display screen 140. For example, each synthetic image may be displayed on a separate display screen. This may allow the images to be displayed in a larger size than if they were both displayed on a single display screen. In this case, the two display screens are preferably color-calibrated in the same way and/or comprise identical display screen hardware. If the images were to be displayed on uncalibrated display screens of different types, it would be more difficult to obtain meaningful comparisons.

The first and second synthetic images, rendered and displayed in the method of Fig. 6, may each comprise an image of a full head of hair. However, this is not essential. As an alternative, each synthetic image may show the appearance of only part of a head of hair. In one example, the first synthetic image may show the left half of a head of hair and the second synthetic image may show the right half of a head of hair (preferably a different head of hair). This will be particularly beneficial when the hairstyle defined by the head parameters is symmetric and preferably has a central parting. Comparing results on two halves of the same head of hair is desirable in the hair care industry. For example, when testing two different dye compositions, in order to isolate the effect of the dyes and neglect potential variations in the underlying hair, it is desirable to dye the left half of the head of a real model with one dye composition and to dye the right half of the same head with the other dye composition. The results can then be compared side by side, on the same type of hair, on the same head. Simulating two half heads may therefore be a helpful way to compare synthetic images. The two synthetic images may be joined together to form a larger image displaying the full head of hair (with different left and right halves).

Several different ways to achieve this can be considered. One approach is to perform the simulation and rendering of the two halves completely separately. This avoids the effect of light that may be scattered from first fibers on the left half of the head before being subsequently scattered by second fibers on the right half of the head (an example of global illumination). However, if the two halves of a real head are dyed and compared direclty, mutual illumination effects such as these are physically possible in the real world. That is, the synthetic images would not emulate the real world experiment precisely. The synthetic images would show each half-head as if the other half head did not exist. Nevertheless, this artificial approach may actually be more desirable in some circumstances - for example, when using the two halves to show a customer how their hair might appear if the whole head was dyed in one of two different ways.

Note that, although each of the two synthetic images will display only half of a head, each simulation may either (i) take into account only the hair fibers on the side of the head to be rendered; or (ii) also take into account hair fibers on the opposite side of the head. In the second case, the simulation can model the effect of mutual illumination, using the assumption that there is a whole head present, covered by hair fibers with the same parameters. In other words, the appearance of a full head of hair having the first set of fiber parameters in the virtual world is simulated, but the first synthetic image that is rendered shows only one half of this head. The appearance will be the same as if an image of the full head had been rendered and then cropped after rendering.

As will be apparent from the foregoing, another possibility is to emulate the real-world experiment as accurately as possible - by simulating a single head in the virtual world that has fibers with the first set of parameters on one side and fibers with the other set of parameters on the other side. This will include mutual illumination between hair fibers of the two different types, (especially near the boundary between the left and right halves).

All of these methods are within the scope of the method illustrated in Fig. 6.

The examples above were described in terms of a single comparison, between synthetic images. However, in some applications, it may be desirable to display the synthetic images to each user in a group of users and collect assessments from all of the users. The assessments can then be analyzed statistically, for example to establish whether there is a statistically significant consensus among the members of the group. A statistical approach based on multiple assessments may help to reduce the influence of individual subjective judgments. Statistical comparisons may be made using full-head comparisons or half-head comparisons.

A useful way of validating the accuracy of the computational model may be to obtain a first set of fiber parameters from hair on a real head of hair and to synthesize an image using those parameters, without modifying them. The synthetic image obtained can then be compared with a real image of the real head of hair (or directly with the real head of hair) to assess how faithfully the synthetic image matches the appearance of the hair on the real head.

Accordingly, disclosed is a method of synthesizing an image showing fibers and assessing that image, the method comprising: providing a computational model describing the interaction of light with fibers; obtaining a first set of fiber parameters, which describes a plurality of real fibers, for use with the model; simulating, using the model and the first set of fiber parameters, how light would interact with the plurality of real fibers; rendering, based on the result of the simulation, a synthetic image showing the appearance of the real fibers; and comparing the appearance of the fibers in the synthetic image with the appearance of the real fibers, to assess the quality of the synthetic image.

In the examples described above, the fibers shown in each synthesized image were human hair fibers. However, as those skilled in the art will appreciate, the present invention is not limited in scope to hair fibers. For example, it may also be used to synthesize images of textiles or other fibrous structures.

Several of the examples above discussed modifying and/or comparing the color of hair, in particular. As those skilled in the art will appreciate, color is not the only attribute of hair that it can be useful to present, inspect, and compare in synthetic images. Other attributes of interest may include those that are affected by hair care products, such as shampoo, conditioner, treatments or styling products. For example, two synthetic images representing treatment by different conditioning products may be compared in order to determine which product provides a more attractive shine.

As discussed already above, fiber parameters of real hair (including but not limited to parameters affecting color) may be physically modified by a chemical treatment of the hair fibers. Such a treatment may comprise applying one or more treatment compositions to the hair. Examples of treatment compositions will now be described.

The composition may comprise oxidative dye precursors, which are usually classified either as primary intermediates (also known as developers) or couplers (also known as secondary intermediates). Various couplers may be used with primary intermediates in order to obtain different shades. Oxidative dye precursors may be free bases or the cosmetically acceptable salts thereof.

Typically, the composition may comprise a total amount of oxidative dye precursors ranging up to about 12%, alternatively from about 0.1% to about 10%, alternatively from about 0.3% to about 8%, alternatively from about 0.5% to about 6%, by weight of the total composition.

Suitable primary intermediates include, but are not limited to: toluene-2,5-diamine, p-phenylenediamine, N-phenyl-p-phenylenediamine, N,N-bis(2-hydroxyethyl)-p-phenylenediamine, 2-hydroxyethyl-p-phenylenediamine, hydroxypropyl-bis-(N-hydroxyethyl-p-phenylenediamine), 2-methoxymethyl-p-phenylenediamine, 2-(1,2-dihydroxyethyl)-p-phenylenediamine, 2,2'-(2-(4-aminophenylamino)ethylazanediyl)diethanol, 2-(2,5-diamino-4-methoxyphenyl)propane-1,3-diol, 2-(7-amino-2H-benzo[b][1,4]oxazin-4(3H)-yl)ethanol, 2-chloro-p-phenylenediamine, p-aminophenol, p-(methylamino)phenol, 4-amino-m-cresol, 6-amino-m-cresol, 5-ethyl-o-aminophenol, 2-methoxy-p-phenylenediamine, 2,2'-methylenebis-4-aminophenol, 2,4,5,6-tetraminopyrimidine, 2,5,6-triamino-4-pyrimidinol, 1-hydroxyethyl-4,5-diaminopyrazole sulfate, 4,5-diamino-1-methylpyrazole, 4,5-diamino-1-ethylpyrazole, 4,5-diamino-1-isopropylpyrazole, 4,5-diamino-1-butylpyrazole, 4,5-diamino-1-pentylpyrazole , 4,5-diamino-1-benzylpyrazole, 2,3-diamino-6,7-dihydropyrazolo[1,2-a]pyrazol-1(5H)-one dimethosulfonate, 4,5-diamino-1-hexylpyrazole, 4,5-diamino-1-heptylpyrazole, methoxymethyl-1,4-diaminobenzene, N,N-bis(2-hydroxyethyl)-N-(4-aminophenyl)-1,2-diaminothane, 2-[(3-aminopyrazolo[1,5-a]pyridin-2-yl)oxy]ethanol hydrochloride, salts thereof and mixtures thereof.

Suitable couplers include, but are not limited to: resorcinol, 4-chlororesorcinol, 2-chlororesorcinol, 2-methylresorcinol, 4,6-dichlorobenzene-1,3-diol, 2,4-dimethylbenzene-1,3-diol, m-aminophenol, 4-amino-2-hydroxytoluene, 2-methyl-5-hydroxyethylaminophenol, 3-amino-2,6-dimethylphenol, 3-amino-2,4-dichlorophenol, 5-amino-6-chloro-o-cresol, 5-amino-4-chloro-o-cresol, 6-hydroxybenzomorpholine, 2-amino-5-ethylphenol, 2-amino-5-phenylphenol, 2-amino-5-methylphenol, 2-amino-6-methylphenol, 2-amino-5-ethoxyphenol, 5-methyl-2-(methylamino)phenol, 2,4-diaminophenoxyethanol, 2-amino-4-hydroxyethylaminoanisole, 1,3-bis-(2,4-diaminophenoxy)-propane, 2,2'-(2-methyl-1,3-phenylene)bis(azanediyl)diethanol, benzene-1,3-diamine, 2,2'-(4,6-diamino-1,3-phenylene)bis(oxy)diethanol, 3-(pyrrolidin-1-yl)aniline, 1-(3-(dimethylamino)phenyl)urea, 1-(3-aminophenyl)urea, 1-naphthol, 2-methyl-1-naphthol, 1,5-naphthalenediol, 2,7-naphthalenediol or 1-acetoxy-2-methylnaphthalene, 4-chloro-2-methylnaphthalen-1-ol, 4-methoxy-2-methylnaphthalen-1-ol, 2,6-dihydroxy-3,4-dimethylpyridine, 2,6-dimethoxy-3,5-pyridinediamine, 3-amino-2-methylamino-6-methoxypyridine, 2-amino-3-hydroxypyridine, 2,6-diaminopyridine, pyridine-2,6-diol, 5,6-dihydroxyindole, 6-hydroxyindole, 5,6-dihydroxyindoline, 3-methyl-1-phenyl-1H-pyrazol-5(4H)-one, 1,2,4-trihydroxybenzene, 2-(benzo[d][1,3]dioxol-5-ylamino)ethanol (also known as hydroxyethyl-3,4-methylenedioxyaniline), and mixtures thereof.

When the composition is obtained by mixing a tint composition and a developer composition, the primary intermediates and couplers are usually incorporated into the tint composition.

The composition may comprise at least one source of an oxidizing agent. Any oxidizing agent known in the art may be used. Preferred oxidizing agents are water-soluble peroxygen oxidizing agents. As used herein, "water-soluble" means that in standard conditions at least about 0.1g, preferably about 1g, more preferably about 10g of the oxidizing agent can be dissolved in 1 liter of deionized water at 25°C. The oxidizing agents are valuable for the initial solubilisation and decolorisation of the melanin (bleaching) and accelerate the oxidation of the oxidative dye precursors (oxidative dyeing) in the hair shaft.

Typically, the composition may comprise a total amount of oxidizing agents ranging from about 0.1 % to about 10%, alternatively from about 1% to about 7%, alternatively from about 2% to about 5%, by weight of the total composition.

Suitable water-soluble oxidizing agents include, but are not limited to: inorganic peroxygen materials capable of yielding hydrogen peroxide in an aqueous solution.

Suitable water-soluble peroxygen oxidizing agents include, but are not limited to: hydrogen peroxide; inorganic alkali metal peroxides (such as sodium periodate and sodium peroxide); organic peroxides (such as urea peroxide and melamine peroxide); inorganic perhydrate salt bleaching compounds (such as the alkali metal salts of perborates, percarbonates, perphosphates, persilicates, persulphates and the like); and mixtures thereof. Inorganic perhydrate salts may be incorporated for example as monohydrates, tetrahydrates. Alkyl/aryl peroxides and/or peroxidases may also be used. Mixtures of two or more such oxidizing agents can be used if desired. The oxidizing agents may be provided in aqueous solution or as a powder which is dissolved prior to use.

In a specific embodiment, the composition comprises a water-soluble oxidizing agent selected from the group consisting of hydrogen peroxide, percarbonates (which may be used to provide a source of both oxidizing agent and carbonate ions and or ammonium ions), persulphates, and mixtures thereof.

When the composition is obtained by mixing a developer composition and a tint composition prior to use, the oxidizing agent may be present in the developer composition. The developer composition may be based on any desired formulation chassis, including any commercial product, for example an oil-in-water emulsion. Typical developer compositions comprise about 6% or about 9% of the H₂O₂ relative to the total weight of the developer composition. A commercial example is the Welloxon® Emulsion with respectively about 6% and about 9% H₂O₂, marketed by Wella and comprising as INCI ingredients: Water, H₂O₂, Cetearyl Alcohol, Ceteareth-25, Salicylic Acid, Phosphoric Acid, Disodium Phosphate, Etidronic Acid.

The composition may comprise an alkalizing agent. Any alkalizing agent known in the art may be used.

Typically, the composition may comprise a total amount of alkalizing agents ranging from about 0.1% to about 10%, alternatively from about 0.5% to about 6%, alternatively from about 1% to about 4%, by weight of the total composition.

Suitable alkalizing agents include, but are not limited to: ammonia; alkanolamines (such as monoethanolamine, diethanolamine, triethanolamine, monopropanolamine, dipropanolamine, tripropanolamine ); 2-amino-2-methyl-1,3-propanediol, 2-amino-2-methyl-1-propanol, and 2-amino-2-hydroxymethyl-1,3-propanediol); guanidium salts; alkali metal and ammonium hydroxides (such as sodium hydroxide); alkali metal and ammonium carbonates; and mixtures thereof. Typical alkalizing agents are ammonia and/or monoethanolamine. Preferably, if present, the ammonium ions and carbonate ions are present in the composition at a weight ratio of from 3:1 to 1:10, alternatively from 2:1 to 1:5.

When the composition is obtained by mixing a developer and a tint composition prior to use, the alkalizing agent is generally present in the tint composition.

References to "displaying" an image, herein, should not be taken as being limited to display on a display screen 140. For example, images may also be displayed to a user by printing them, preferably using a color calibrated printer.

The examples described above involved generating a single two-dimensional synthetic image in each instance. However, the method can be extended to generating multiple synthetic images. For example, multiple synthetic images can be generated from respective different viewpoints (that is, positions and orientations of a the virtual camera, in the simulation). Two synthetic images of the same scene may be rendered from different viewpoints such that they form a left-right stereo pair. In this way, a three-dimensional synthetic image can be created. Furthermore, instead of merely rendering a 2D or 3D still image, it is possible to render a sequence of such images, to form a moving image (that is, a video). In a sequence of images of hair fibers, at least one (or a combination of any two or more) of the following may vary: the position or orientation of the head; the positions or shapes of fibers on the head; the position or orientation of a light source; and the position or orientation of a virtual camera, in the simulation. The image-comparison methods described above can be modified so that a comparison is performed between still images or moving images, in 2D or 3D.

In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements. The embodiments may be implemented by means of hardware comprising several distinct elements. In a device claim enumerating several means, several of these means may be embodied by one and the same item of hardware. The mere fact that certain measures are recited in mutually different dependent claims does not indicate that a combination of these measures cannot be used to advantage. Furthermore in the appended claims lists comprising "at least one of: A; B; and C" should be interpreted as (A and/or B) and/or C.

In general, the various embodiments may be implemented in hardware or special purpose circuits, software, logic or any combination thereof. For example, some aspects may be implemented in hardware, while other aspects may be implemented in firmware or software which may be executed by a controller, microprocessor or other computing device, although these are not limiting examples. While various aspects described herein may be illustrated and described as block diagrams, flow charts, or using some other pictorial representation, it is well understood that these blocks, apparatus, systems, techniques or methods described herein may be implemented in, as non-limiting examples, hardware, software, firmware, special purpose circuits or logic, general purpose hardware or controller or other computing devices, or some combination thereof.

The embodiments described herein may be implemented by computer software executable by a data processor of the apparatus, such as in the processor entity, or by hardware, or by a combination of software and hardware. Further in this regard, it should be noted that any blocks of the logic flow as in the Figures may represent program steps, or interconnected logic circuits, blocks and functions, or a combination of program steps and logic circuits, blocks and functions. The software may be stored on such physical media as memory chips, or memory blocks implemented within the processor, magnetic media such as hard disk or floppy disks, and optical media such as for example DVD and the data variants thereof, or CD.

The memory may be of any type suitable to the local technical environment and may be implemented using any suitable data storage technology, such as semiconductor-based memory devices, magnetic memory devices and systems, optical memory devices and systems, fixed memory and removable memory. The data processors may be of any type suitable to the local technical environment, and may include one or more of general purpose computers, special purpose computers, microprocessors, digital signal processors (DSPs), application specific integrated circuits (ASIC), gate level circuits and processors based on multi-core processor architecture, as non-limiting examples.

Embodiments as discussed herein may be practiced in various components such as integrated circuit modules. The design of integrated circuits is by and large a highly automated process. Complex and powerful software tools are available for converting a logic level design into a semiconductor circuit design ready to be etched and formed on a semiconductor substrate. Programs, such as those provided by Synopsys, Inc. of Mountain View, California and Cadence Design, of San Jose, California automatically route conductors and locate components on a semiconductor chip using well established rules of design as well as libraries of pre-stored design modules. Once the design for a semiconductor circuit has been completed, the resultant design, in a standardized electronic format (e.g., Opus, GDSII, or the like) may be transmitted to a semiconductor fabrication facility or "fab" for fabrication.

The dimensions and values disclosed herein are not to be understood as being strictly limited to the exact numerical values recited. Instead, unless otherwise specified, each such dimension is intended to mean both the recited value and a functionally equivalent range surrounding that value. For example, a dimension disclosed as "40 mm" is intended to mean "about 40 mm."

## Claims

1. A method of synthesizing an image showing fibers, the method comprising:
providing (210) a computational model describing the interaction of light with fibers;
obtaining (220) a first set of fiber parameters, which describes a plurality of real fibers (160), for use with the model;
modifying (230) the first set of fiber parameters, to produce a second set of fiber parameters describing a plurality of modified fibers;
simulating (240), using the model and the second set of fiber parameters, how light would interact with the modified fibers; and
rendering (250), based on the result of the simulation, a synthetic image showing the appearance of the modified fibers.

2. The method of claim 1, wherein each of the first and second sets of fiber parameters comprises parameters for at least three of the following four components:
a first backward scattering component, describing how incident light is reflected from a first surface of a fiber;
a first forward scattering component, describing how incident light is transmitted through the first surface of the fiber and a second surface of the fiber;
a second backward scattering component, describing how incident light is transmitted through the first surface of the fiber, reflected from the second surface of the fiber, and transmitted through a third surface of the fiber; and
an absorption component, describing how incident light is absorbed by the fiber.

3. The method of claim 1 or claim 2, wherein modifying (230) the first set of parameters comprises modifying at least one parameter related to a color of the real fibers, whereby the second set of parameters describes fibers having a modified color.

4. The method of any preceding claim, wherein obtaining (220) the first set of fiber parameters comprises:
obtaining (221) an image of the plurality of real fibers;
processing (222) the image to determine a set of estimated fiber parameters;
simulating (223), using the model and the estimated fiber parameters, how light would interact with fibers with the estimated parameters;
computing (224) an error metric comparing the result of the simulation with the content of the image;
updating (225) the estimated parameters, based on the error metric;
iterating the steps of simulating (223), computing (224), and updating (225), until the estimated fiber parameters converge to stable values; and
determining (227) the first set of fiber parameters based on the converged estimated fiber parameters.

5. The method of any preceding claim, wherein each of the first and second sets of fiber parameters comprises parameters describing an average fiber; and the model describes respective individual fibers by combining the parameters of the average fiber with a random perturbation.

6. The method of any preceding claim, wherein the synthetic image comprises a plurality of pixels corresponding to a respective plurality of spatial positions in a virtual image plane, and wherein simulating how light would interact with the modified fibers comprises simulating, for each of a plurality of rays of light arriving at each position, a journey of the ray from a light source to the position, said journey including an interaction with one or more of the modified fibers,
wherein the simulation comprises calculations (242a, 243a, 244a, 242b, 243b, 244b) performed in parallel by two or more computing devices (120a, 120b), each computing device (120a, 120b) simulating, for each position, the journeys of a subset of the plurality of rays to that position.

7. The method of any preceding claim, wherein the step of rendering the synthetic image comprises calculating a pixel value by combining contributions to the pixel from the plurality of rays,
wherein the method comprises rendering (251) and displaying a preliminary synthetic image before the simulation has completed, based on the contributions to each pixel from rays that have been simulated up to the current time.

8. The method of any preceding claim, wherein the second set of fiber parameters includes at least one parameter that has a different value for at least one of the following:
different fibers among the plurality of fibers; and
different parts of the same fiber.

9. The method of any preceding claim, further comprising
obtaining (260) light source parameters for use with the model, which describe a light source;
the method comprising simulating (240), using the model, the light source parameters, and the second set of fiber parameters, how light from the light source would interact with the modified fibers,
wherein the light source parameters comprise an omnidirectional image of a real scene.

10. The method of any preceding claim, wherein:
the first set of fiber parameters is obtained by analyzing a sample of hair (160); and
the step of modifying (230) the first set of parameters comprises modifying at least one parameter related to a color of the hair, whereby the second set of parameters describes the person's hair with a modified color,
wherein the method further comprises displaying (270) the rendered synthetic image, to illustrate how the hair would appear if it had the modified color.

11. The method of claim 10, further comprising formulating a hair dye composition, using the appearance of the hair in the synthetic image as a reference.

12. The method of claim 10 or claim 11, further comprising
obtaining (280) head parameters for use with the model, which describe the positions of a plurality of hair fibers on a head, defining a hairstyle,
the method comprising simulating (240), using the model, the head parameters, and the second set of fiber parameters, how light would interact with the modified fibers in the positions described by the head parameters.

13. One or more processor-readable storage devices containing processor readable code for programming one or more processors to perform a method according to any preceding claim.

14. An image processing apparatus comprising:
a memory (110); and
at least one processor (120, 120a, 120b) adapted to:
obtain (220) a first set of fiber parameters for a computational model of interactions between light and fibers, said first set of fiber parameters describing a plurality of real fibers (160);
modify (230) the first set of fiber parameters, to produce a second set of fiber parameters describing a plurality of modified fibers;
simulate (240), using the model and the second set of fiber parameters, how light would interact with the modified fibers;
render (250), based on the result of the simulation, a synthetic image showing the appearance of the modified fibers; and
store the rendered synthetic image in the memory (110).

15. The image processing apparatus of claim 14, wherein:
the synthetic image comprises a plurality of pixels corresponding to a respective plurality of spatial positions in a virtual image plane;
the at least one processor comprises at least one first processor (120a) in a first computer (130a) and at least one second processor (120b) in a second computer (130b), the first computer (130a) and the second computer (130b) configured to be connected over a network;
each processor (120a, 120b) is adapted to simulate how light would interact with the modified fibers by simulating, for each of a plurality of rays of light arriving at each position, a journey of that ray from a light source to the position, said journey including one or more interactions with one or more of the modified fibers;
each processor (120a, 120b) is adapted to perform calculations (242a, 243a, 244a, 242b, 243b, 244b) in parallel with the other processor; and
each processor (120a, 120b) is adapted to simulate (242a, 243a, 244a, 242b, 243b, 244b), for each position, the journeys of a respective different plurality of rays.
